# EUROPÄISCHE PATENTSCHRIFT

(11) **EP 3 050 413 B1**
(45) Veröffentlichungstag und Bekanntmachung des Hinweises auf die Patenterteilung: **08.11.2017**
(21) Anmeldenummer: 14772334.0
(22) Anmeldetag: 24.09.2014
(51) Int. Cl.: H05K 7/20

(54) **LÜFTEREINRICHTUNG**
FAN DEVICE
DISPOSITIF DE VENTILATION

(30) Priorität: 25.09.2013 DE 102013015985
(43) Veröffentlichungstag der Anmeldung: 03.08.2016
(73) Patentinhaber: STEGO-Holding GmbH, 74523 Schwäbisch Hall (DE)
(72) Erfinder: DENT, Robert, 74523 Schwäbisch Hall (DE); SCHANZENBACH, Bernd Armin, 74535 Mainhardt Geisselhardt (DE); MANGOLD, Elmar, 73485 Zöbingen Unterschneidheim (DE)
(74) Vertreter: Bohnenberger, Johannes
(86) Internationale Anmeldenummer: PCT/EP2014/070366
(87) Internationale Veröffentlichungsnummer: WO 2015/044198

(56) Entgegenhaltungen:
- WO-A1-2008/001396
- DE-A1- 19 607 590
- DE-A1-102007 004 018
- DE-A1-102010 016 504
- US-A- 2 775 010

## Beschreibung

Die Erfindung betrifft eine Lüftereinrichtung gemäß dem Obergriff des Anspruchs 1.

Lüftereinrichtungen der hier angesprochenen Art sind grundsätzlich bekannt. Sie umfassen einen Lüfterträger und einen Lüfter, der durch den Lüfterträger gehalten wird. Die Lüftereinrichtungen dieser Art sind zur Befestigung an einem Schaltschrank vorgesehen und dienen zur Belüftung desselben. Hierzu wird mittels des Lüfters kalte Luft über eine dem Lüfter vorgelagerte Filtermatte eingesaugt und über eine weiter oben im Schaltschrank gelagerte Ausgangsfiltermatte wieder hinausgedrückt. Die Befestigung der bekannten Lüftereinrichtungen an dem Schaltschrank erfolgt in der Regel derart, dass die Lüftereinrichtung in eine geeignete in die Schaltschrankwand eingebrachte Ausnehmung eingesetzt wird. Die Verriegelung zwischen der Lüftereinrichtung und der Schaltschrankwand erfolgt dabei derart, dass die Lüftereinrichtung mit einem erheblichen Druck in der Einsetzrichtung in die Ausnehmung gepresst wird, bis ein an der Lüftereinrichtung befestigtes Rastelement die Schaltschrankwand passiert hat und diese hinterrastet. Diese Lösung ist insofern mit Nachteilen behaftet, als es durch den ausgeübten Druck zu einer starken Durchbiegung der Schrankwand während der Befestigung der Lüftereinrichtung kommen kann, insbesondere dann, wenn die Schrankwand eine Wölbung aufweist. Hieraus resultieren Lücken zwischen der Schaltschrankwand und der Lüftereinrichtung, die mit einer aufgeschäumten Dichtung ausgeglichen werden müssen.

Aufgabe der vorliegenden Erfindung ist es daher, eine Lüftereinrichtung zu schaffen, die eine Verformung der Schrankwand durch die Befestigung der Lüftereinrichtung vermeidet.

Zur Lösung der oben genannten Aufgabe wird eine Lüftereinrichtung mit den Merkmalen des Anspruchs 1 vorgeschlagen. Die Lüftereinrichtung umfasst mindestens ein Verriegelungselement zur Befestigung der Lüftereinrichtung an einem eine Vorder- und Rückseite aufweisenden Wandabschnitt, insbesondere an einer Schaltschrankwand. Die Lüftereinrichtung zeichnet sich dadurch aus, dass die Lüftereinrichtung dazu ausgebildet ist, drucklos in eine vorderseitige Wandabschnittöffnung eingeführt zu werden, und dass das Verriegelungselement im eingeführten Zustand in Richtung der Rückseite des Wandabschnitts verlagerbar ist. Hierzu ist das mindestens eine Verri egelungselement vorzugsweise beweglich an der Lüftereinrichtung gelagert und ist zur Befestigung der Lüftereinrichtung an dem Wandabschnitt manuell von einer Einbaustellung in eine Fixierstellung verlagerbar, in der es an der Rückseite des Wandabschnitts angreift.

Ein wesentlicher Punkt der Erfindung liegt somit darin, dass bei der Befestigung kein erheblicher Überdruck auf die Lüftereinrichtung ausgeübt werden muss, um ein Verrasten der Lüftereinrichtung mit der Schaltschrankwand zu erreichen. Ganz im Gegenteil ermöglicht die vorliegende Erfindung eine widerstandslose Positionierung der Lüftereinrichtung in einer Wandabschnittöffnung. Zwar wird die Lüftereinrichtung also ebenfalls in eine entsprechende Ausnehmung in der Wand eingeführt, die Einführung erfolgt jedoch in vorteilhafterweise drucklos. Die Fixierung der Lüftereinrichtung erfolgt durch eine punktuelle Druckausübung auf die Rückseite des Wandabschnitts durch die manuelle Betätigung des Verriegelungselements, welches hierzu vorzugsweise beweglich an der Lüftereinrichtung gelagert ist. Eine entsprechende Fixierung, insbesondere eine Verriegelung oder ein Verrasten der Lüftereinrichtung an dem Wandabschnitt, kann beispielsweise aufgrund einer Dreh- oder Ziehbewegung erfolgen. Durch diese Bewegung wird das Verriegelungselement von hinten, d. h. vom Inneren des Schaltschrankes aus an die rückseitige Schaltschrankwand herangedrückt bzw. herangezogen. Auf diese Weise wird eine gezielte punktuelle Verbindung zwischen der Lüftereinrichtung und einer Schaltschrankwand hergestellt, ohne dass die Gefahr besteht, dass sich die Schaltschrankwand aufgrund eines ausgeübten Drucks während des Einführens der Lüftereinrichtung in die Wandabschnittöffnung verbiegt.

Besonders bevorzugt wird eine Lüftereinrichtung, bei der das Verriegelungselement den Wandabschnitt zumindest in der Fixierstellung hintergreift. Bei einer derartigen Ausführungsform der Erfindung kann das Verriegelungselement darüber hinaus in der Einbaustellung das Einführen der Lüftereinrichtung in eine entsprechende Öffnung eines Wandabschnitts erlauben, während erst durch die Verlagerung in die Fixierstellung eine Verriegelung, d. h. eine feste Verbindung zwischen der Lüftereinrichtung und dem Wandabschnitt erfolgt. Der ausgeübte Druck auf den Wandabschnitt reduziert sich somit punktuell auf die Bereiche der Verriegelungselemente, wobei der Druck jedoch nicht von vorne, sondern von hinten, d. h. vom Inneren des Schaltschrankes aus auf den Wandabschnitt ausgeübt wird. Eine Verformung des Wandabschnitts wird dadurch vermieden.

Vorzugsweise ist vorgesehen, dass das mindestens eine Verriegelungselement ein Gehäuse der Lüftungseinrichtung durchgreift und relativ dazu verlagerbar ist. Auf diese Weise kann das Verriegelungselement einfach von einer Einbaustellung in eine Fixierstellung verlagert werden. Vorzugsweise ist jeweils ein Verriegelungselement in einem inneren Randbereich der Lüftungseinrichtung und insbesondere in mindestens zwei Eckbereichen eines Lüfterträgers angeordnet. Es kann auch vorgesehen sein, dass in jedem der vier Eckbereiche des Lüfterträgers jeweils ein Verriegelungselement angeordnet ist. Alternativ kann ein Verriegelungselement auch in einem Seitenbereich eines Lüfterträgers, d. h. also in einem Bereich zwischen zwei Eckbereichen, angeordnet sein.

Das Verriegelungselement ist so ausgebildet, dass es zur Befestigung der Lüftungseinrichtung an verschieden dicke Wandabschnitte stufenlos anpassbar ist. Dies bedeutet, dass das Verriegelungselement vorzugsweise ohne Stufen ausgebildet ist und folglich in Verbindung mit sämtlichen gebräuchlichen Wandstärken verwendet werden kann. Bei einer alternativen Ausführungsform der Erfindung kann vorgesehen sein, dass das Verriegelungselement zur Befestigung der Lüftereinrichtung an unterschiedlich dicken Wandabschnitten mehrere Rastpositionen einnehmen kann. Die Rastpositionen sind dann vorzugsweise auf die gebräuchlichsten Wandstärken, insbesondere solche von Schaltschränken, abgestimmt.

Das Verriegelungselement ist als Drehriegel , der drehbar an der Lüftereinrichtung gelagert ist oder als Lasche mit einem daran befestigten Spannhaken ausgebildet, wobei die Lasche zusammen mit dem Spannhaken entgegen einer Einbaurichtung der Lüftereinrichtung geradlinig verschiebbar ist. Um die Bewegungsrichtung des Verriegelungselements festzulegen, kann eine Führungseinrichtung vorgesehen sein, die eine fehlerhafte manuelle Verlagerung des Verriegelungselements vermeidet.

Zur Lösung der oben genannten Aufgabe wird auch ein Verriegelungselement mit den Merkmalen des Anspruchs 13 vorgeschlagen. Das Verriegelungselement dient zur Befestigung einer Lüftereinrichtung an einem Wandabschnitt, insbesondere an einer Schaltschrankwand. Das Verriegelungselement ist vorzugsweise dazu ausgebildet, mit einem ersten Abschnitt an einem Wandabschnitt und mit einem zweiten Abschnitt an einer Lüftereinrichtung angebracht, insbesondere angeklemmt zu werden.

Auch bei dieser Ausführungsform der Erfindung ist es besonders vorteilhaft, dass eine übermäßige Druckbeaufschlagung der Lüftereinrichtung und des damit zu verbindenden Wandabschnitts vermieden wird. Vielmehr erfolgt eine Befestigung der Lüftereinrichtung an einem Wandabschnitt mittels separat ausgebildeter Verriegelungselemente, die sowohl an dem Wandabschnitt als auch an der Lüftereinrichtung angeklemmt bzw. angeklippt werden.

Vorzugsweise weist der erste Abschnitt des Verriegelungselements einen Aufnahmebereich zur Aufnahme des Wandabschnitts auf. Um unterschiedlich dicke Wandabschnitte aufnehmen zu können, ist der Aufnahmebereich des ersten Abschnitts vorzugsweise aufweitbar ausgebildet. Insbesondere kann der Aufnahmebereich elastisch in Form eines Federelements ausgebildet sein, so dass das Verriegelungselement universell für verschieden dicke Wandabschnitte zum Einsatz kommen kann.

Um eine Befestigung des Verriegelungselements an einer Lüftereinrichtung zu bewirken, weist der zweite Abschnitt vorzugsweise ein Spannfederelement auf bzw. ist als ein solches ausgebildet. Durch das Spannfederelement kann eine klemmende Verbindung zwischen dem Verriegelungselement und der Lüftereinrichtung bewerkstelligt werden. Vorzugsweise ist vorgesehen, dass der erste und der zweite Abschnitt im Wesentlichen einen rechten Winkel miteinander einschließen.

Das Verriegelungselement gemäß der Erfindung kann einen Teil einer Lüftereinrichtung bilden, wobei die Lüftereinrichtung mindestens eine Öffnung zur Aufnahme des zweiten Abschnitts des Verriegelungselements aufweist. Auf diese Weise kann eine vorteilhafte klemmende Verbindung zwischen der Lüftereinrichtung und dem Verriegelungselement und damit zwischen der Lüftereinrichtung und dem Wandabschnitt bewerkstelligt werden.

Die Erfindung wird im Folgenden anhand der Zeichnung näher erläutert. Es zeigen:
- Fig. 1: eine perspektivische Darstellung einer Lüftereinrichtung mit drei unterschiedlichen Verriegelungselementen;
- Fig. 2: eine Detailansicht eines Verriegelungselements gemäß einer ersten Ausführungsform der Erfindung;
- Fig. 3: eine Detailansicht eines Verriegelungselements gemäß einer zweiten Ausführungsform der Erfindung;
- Fig. 4: eine Detailansicht des Verriegelungselements gemäß der zweiten Ausführungsform der Erfindung in einer Fixierstellung;
- Fig. 5: eine Detailansicht eines Verriegelungselements gemäß einer dritten Ausführungsform in einer Verriegelungsposition;
- Fig. 6: eine Detailansicht des Verriegelungselements gemäß einer dritten Ausführungsform, und
- Fig. 7: eine perspektivische Darstellung eines Verriegelungselements gemäß der dritten Ausführungsform.

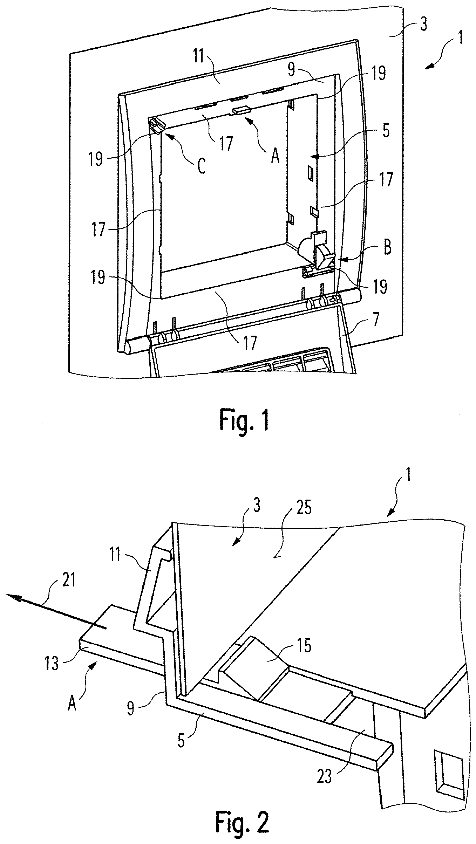

Die Figur 1 zeigt eine Lüftereinrichtung 1, die an einem Wandabschnitt 3 angebracht ist, wobei der Wandabschnitt 3 beispielsweise eine Schaltschrankwand sein kann. Die Lüftereinrichtung 1 umfasst einen Lüfterträger 5, der zur Aufnahme eines in der Figur nicht gezeigten Lüfters dient. In dem in Figur 1 gezeigten Einbauzustand der Lüftereinrichtung 1 in einem Schaltschrank, ist der Lüfter somit innerhalb des Schaltschranks angeordnet.

Um zu vermeiden, dass über die Lüftereinrichtung 1 Staub in den Schaltschrank eintritt, ist die Lüftereinrichtung 1 vorzugsweise mit einer Abdeckhaube 7 versehen, die in der Figur 1 in einem geöffneten Zustand gezeigt ist. Die Abdeckhaube 7 kann zur Aufnahme einer Filtermatte oder eines sonstigen Filterelements dienen und ist im betriebsbereiten Zustand der Lüftereinrichtung 1 im Bereich einer Stufe 9 des Lüfterträgers 5 angeordnet. Die Stufe 9 bildet folglich eine Aussparung zur Aufnahme der Abdeckhaube 7 und ist von einem Rahmen 11 des Lüfterträgers 5 umgeben, der sich mit seiner Rückseite an dem Wandabschnitt 3 abstützt.

In der Darstellung nach Figur 1 ist die Lüftereinrichtung 1 mit drei unterschiedlichen beispielhaften Verriegelungselementen A, B und C versehen, die hier lediglich zu Vergleichszwecken in einer einzigen Lüftereinrichtung 1 dargestellt sind.

Die Figur 2 zeigt eine Detaildarstellung einer ersten Ausführungsform der Erfindung, bei der das Verriegelungselement A als Lasche 13 mit einem daran angebrachten Spannhaken 15 ausgebildet ist. Das Verriegelungselement A durchgreift die Stufe 9 des Lüfterträgers 5 und ist somit in einem inneren Randbereich der Lüftereinrichtung 1 bzw. des Lüfterträgers 5 angeordnet.

Wie aus der Figur 1 erkennbar ist, ist das Verriegelungselement A in einem Seitenbereich 17 der Stufe 9 angeordnet, der sich zwischen zwei Eckbereichen 19 des Lüfterträgers 5 erstreckt.

Wie die Figur 2 verdeutlicht, ist das Verriegelungselement A relativ zu dem Lüfterträger 5 entgegen einer Einbaurichtung, nämlich in Richtung des Pfeils 21 verlagerbar. Mit anderen Worten ist das Verriegelungselement A entgegengesetzt zu der Richtung verlagerbar, in der die Lüftereinrichtung 1 in eine entsprechende Ausnehmung des Wandabschnitts 3 eingeführt wird. Die Bewegungsrichtung 21 des Verriegelungselements A wird durch eine Führungseinrichtung 23 festgelegt, die in Form einer Aussparung in dem Lüfterträger 5 vorgesehen ist und in der sich das Verriegelungselement A gleitend bewegen kann. Die Bewegungsrichtung 21 des Verriegelungselements verläuft dabei im Wesentlichen senkrecht zu der Ebene des Wandabschnitts 3.

Der Einbau und die Befestigung der Lüftereinrichtung 1 an dem Wandabschnitt 3 erfolgt bei dieser Ausführungsform der Erfindung derart, dass die Lüftereinrichtung 1 in eine entsprechende Ausnehmung des Wandabschnitts 3 eingeführt wird. Hierbei befindet sich das Verriegelungselement A in einer Einbaustellung, sodass das Einführen der Lüftereinrichtung 1 in die Ausnehmung des Wandabschnitts nicht behindert wird. Das Verriegelungselement A bzw. die Lasche 13 wird daraufhin in der Bewegungsrichtung 21 gezogen, so dass sich der Spannhaken 15 auf die Innenseite 25 des Wandabschnitts 3 zubewegt. Der Zug auf die Lasche 13 erfolgt solange, bis der Spannhaken 15 an der Innenseite 25 des Wandabschnitts 3 anliegt und damit seine Fixierstellung erreicht hat. Dadurch, dass das Verriegelungselement A in der Einbaurichtung 25 verlagerbar ist, kann sie für beliebige Wanddicken verwendet werden.

Der Spannhaken ist insbesondere keilförmig ausgebildet und wird so gegen die Innenseite 25 des Wandabschnitts 3 gezogen, dass ein Anpressdruck zwischen der Lüftereinrichtung 1 und dem Wandabschnitt 3 erzeugt wird. Eine Verriegelung des Verriegelungselements A erfolgt vorzugsweise durch entsprechende Rastelemente, die beispielsweise zwischen der Führungseinrichtung 23 und der Lasche 13 angebracht sein können. Grundsätzlich denkbar ist jedoch auch ein anderer Verriegelungsmechanismus, der eine weitergehende relative Verlagerung zwischen dem Verriegelungselement A und der Lüftereinrichtung 1 bzw. dem Lüfterträger 5 verhindert.

In der Figur 1 umfasst die Lüftereinrichtung 1 lediglich ein Verriegelungselement A. Denkbar ist es jedoch grundsätzlich auch, dass mehr als einer und insbesondere jeder der Seitenbereiche 17 mit einem Verriegelungselement A versehen ist.

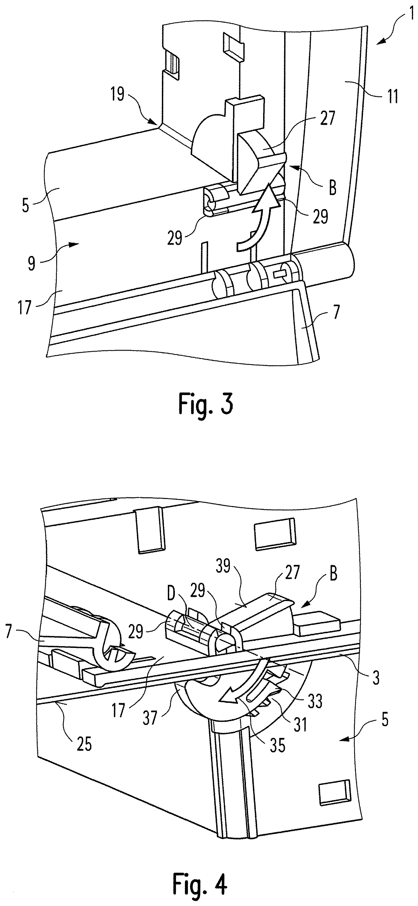

Die Figuren 3 und 4 zeigen eine Detaildarstellung eines Verriegelungselements B gemäß der zweiten Ausführungsform der Erfindung. Bei dieser Ausführungsform ist das Verriegelungselement B als Drehriegel 27 ausgebildet, der mittels eines Lagers 29 drehbar an der Lüftereinrichtung 1 und insbesondere an dem Lüfterträger 5 gelagert ist. Die Drehachse D des Drehriegels 27 ist im Wesentlichen parallel zu einem Wandabschnitt 3 angeordnet, wenn die Lüftereinrichtung 1 mit diesem Wandabschnitt 3 in Verbindung steht. Wie die Figur 3 und insbesondere auch die Figur 4 zeigen, durchgreift der Drehriegel 27 das Gehäuse und durchgreift insbesondere die Stufe 9 in einem Eckbereich 19 des Lüfterträgers 5. Die Innenseite der Stufe 9 bildet zudem die Auflagefläche für den Wandabschnitt 3, der im fixierten Zustand zwischen dem geschlossenen Drehriegel 27 und der Auflagefläche angeordnet ist.

Der Drehriegel 27 ist im Wesentlichen teilkreis- bzw. hakenförmig ausgebildet und wirkt mit in den Lüfterträger 5 integrierten Raststufen 31 zusammen, in die eine an dem Drehriegel 27 vorgesehene Rastnase 33 während der Verlagerung des Drehriegels 27 in der Drehrichtung 35 eingreifen kann. Die Drehrichtung 35 steht im Wesentlichen senkrecht auf eine Ebene des Wandabschnitts 3 in einem Einbauzustand der Lüftereinrichtung 1. Die Raststufen 31 sind entlang der Bewegungsrichtung des Drehriegels 27 angeordnet. Je weiter der Drehriegel 27 in der Drehrichtung 35 gedreht wird, umso näher gelangt ein distales Ende 37 des Drehriegels 27 an eine Innenseite 25 des Wandabschnitts 3 heran. Der Drehriegel 27 wird solange in der Drehrichtung 35 gedreht und die Rastnase 33 rastet folglich in aufeinanderfolgende Raststufen 31 ein, bis das distale Ende 37 des Drehriegels 27 an die Innenseite 25 des Wandabschnitts 3 anstößt. Durch ein Einrasten der Rastnase 33 in den Raststufen 31 des Lüfterträgers 5, ist ein Lösen des Drehriegels 27 aus der Fixierstellung (s. Figur 4) nicht mehr möglich.

Eine Befestigung der Lüftereinrichtung 1 an einem Wandabschnitt 3 erfolgt mit dem Verriegelungselement B gemäß der zweiten Ausführungsform der Erfindung also wie folgt:
Zunächst wird die Lüftereinrichtung 1 in eine entsprechende Ausnehmung in dem Wandabschnitt 3 eingeführt, wobei der Ausschnitt in dem Wandabschnitt 3 an die Kontur und die Größe der Lüftereinrichtung 1 bzw. insbesondere an die Abmessungen des Lüfterträgers 5 angepasst ist. Das Verriegelungselement befindet sich hierbei in einer Einbaustellung, in der das Einführen der Lüftereinrichtung in die Ausnehmung des Wandabschnitts nicht behindert wird. Nach dem Einfügen des Lüfterträgers 5 in die Ausnehmung des Wandabschnitts 3 erfolgt eine manuelle Betätigung des Drehriegels 27, in dem ein Benutzer eine Kraft auf eine Druckfläche 39 ausübt, so dass der Drehriegel 27 um seine Drehachse D herum in der Drehrichtung 35 verlagert wird. Die Rastnase 33 rastet hierbei sukzessive in die in den Lüfterträger 5 integrierten Raststufen 31 ein, bis das distale Ende 37 an die Innenseite 25 des Wandabschnitts 3 anstößt und folglich seine Fixierstellung einnimmt.

Vorzugsweise sind die Anzahl und die Ausprägungen der Raststufen in Kombination mit der Rastnase 33 auf unterschiedliche Wanddicken abgestimmt. Jede Raststufe 31 ermöglicht folglich die Aufnahme eines unterschiedlich dicken Wandabschnitts 3. Im vorliegenden Beispiel sind lediglich vier Raststufen 31 dargestellt. Es versteht sich jedoch, dass auch eine feinere Rasterung vorgesehen sein kann, die ein breiteres Spektrum an Wandstärken zulässt und damit noch flexibler einsetzbar ist.

In der Figur 1 ist lediglich in einem Eckbereich 19 des Lüfterträgers 5 ein einzelnes Verriegelungselement B dargestellt. Es versteht sich jedoch, dass zu einer sicheren Befestigung der Lüftereinrichtung 1 an einem Wandabschnitt 3 vorzugsweise in wenigstens zwei, insbesondere in jeder der vier Ecken 19 des Lüfterträgers 5 jeweils ein Verriegelungselement B angebracht sein kann.

Während der Befestigung der Lüftereinrichtung 1 an dem Wandabschnitt 3 muss jedes der Verriegelungselemente B manuell betätigt werden, um ein Hintergreifen des Wandabschnitts 3 mittels des Drehriegels 27 zu bewirken. Wie insbesondere die Figur 4 deutlich macht, ist bei dieser Ausführungsform ebenfalls gewährleistet, dass lediglich eine punktuelle Druckausübung auf den Wandabschnitt 3 erfolgt, der darüber hinaus nicht von vorne, sondern von hinten erfolgt, d. h. auf die Innenseite 25 des Wandabschnitts 3 wirkt. Ein Verbiegen des Wandabschnitts ist damit ausgeschlossen.

Das Verriegelungselement B kann grundsätzlich von der Innenseite des Wandabschnitts her, beispielsweise mittels eines Schraubendrehers geöffnet werden. Weiterhin kann die Druckfläche 39 mit einer Riffelung versehen sein, sodass der Druck auch mit einem Werkzeug, beispielsweise mit einem Schraubendreher, ausgeübt werden kann.

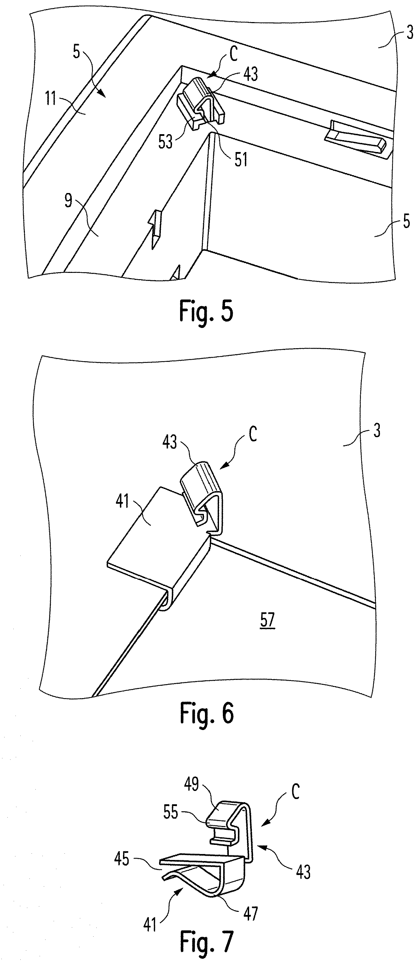

Die Figuren 5 bis 7 zeigen noch eine weitere Ausführungsform eines Verriegelungselements C, das vollständig getrennt von der Lüftereinrichtung 1 und dem Wandabschnitt 3 ausgebildet ist. Das Verriegelungselement C umfasst einen ersten Abschnitt 41 und einen zweiten Abschnitt 43, die im Wesentlichen in einem rechten Winkel zueinander angeordnet sind. Der erste Abschnitt 41 weist einen Federarm 47 derart auf, dass der Aufnahmebereich 45 zur Aufnahme von unterschiedlichen dicken Wandabschnitten aufweitbar ausgebildet ist. Der elastische Federarm 47 sorgt bei jeder Wandstärke für eine feste Klemmverbindung zwischen dem Verriegelungselement C und dem Wandabschnitt 3. Der erste Abschnitt 41 ist mit anderen Worten im Wesentlichen u-förmig oder klammerartig ausgebildet und umgreift auf diese Weise einen Wandabschnitt 3, so dass der erste Abschnitt 41 an beiden Seiten eines Wandabschnitts 3 anliegt.

Der zweite Abschnitt 43 umfasst ein Spannfederelement 49, das zur Aufnahme in einer Ausnehmung 51 eines Lüfterträgers 5 vorgesehen ist, um dort mit mindestens einem Vorsprung 53 in klemmenden bzw. rastenden Eingriff zu gelangen. Das Spannfederelement 49 ist derart elastisch ausgebildet, dass ein Federarm 55 verlagerbar ist, wenn das Spannfederelement 49 durch die Öffnung 51 in dem Lüfterträger 5 geführt wird und sich nach der Durchführung durch die Öffnung 51 wieder entspannt und mit dem Vorsprung 53 in Eingriff kommt. Auf diese Weise verhindert das Spannfederelement 49 bzw. der Federarm 55, dass der zweite Abschnitt 43 durch die Öffnung 51 wieder von der Lüftereinrichtung 1 gelöst werden kann.

Eine Befestigung einer Lüftereinrichtung 1 an einem Wandabschnitt 3 mit dem Verriegelungselement C erfolgt somit insgesamt wie folgt:
Zunächst wird, wie in der Figur 6 gezeigt ist, das Verriegelungselement C mit einem Wandabschnitt 3, insbesondere in einem Eckbereich einer entsprechenden Ausnehmung 57 zur Aufnahme der Lüftereinrichtung 1 verbunden. Konkret wird der Wandabschnitt 3 in den Aufnahmebereich 45 des ersten Abschnitts 41 geführt. Der zweite Abschnitt 43 steht in dieser Position im Wesentlichen in einem 90° Winkel von der Oberfläche des Wandabschnitts 3 ab. Anschließend wird die Lüftereinrichtung 1 in die Ausnehmung 57 des Wandabschnitts 3 eingeführt. Während dieses Vorgangs wird durch die Ausübung eines gewissen Drucks auf die Eckbereiche 19 des Lüfterträgers 5 das Spannfederelement 49 des Verriegelungselements C durch die Öffnung 51 des Lüfterträgers 5 gedrückt, bis der Federarm 55 die Ausnehmung 51 durchlaufen hat und in der Endposition (Fixierstellung) auseinanderschnappt, um mit dem Vorsprung 53 in Eingriff zu kommen. Ein Lösen der Lüftereinrichtung 1 von dem Wandabschnitt 3 ist in dieser Fixierstellung des Verriegelungselements C nicht mehr möglich. Es versteht sich, dass die Positionierung der Verriegelungselemente C und die (Durchgangs-) Öffnungen 51 in dem Lüfterträger 5 positionsgenau aufeinander abgestimmt sein müssen.

In der Figur 1 weist die Lüftereinrichtung 1 lediglich ein Verriegelungselement C in einem Eckbereich 19 des Lüfterträgers 5 auf. Es versteht sich jedoch, dass vorzugsweise ein Verriegelungselement C wenigstens in zwei und vorzugsweise in sämtlichen vier Eckbereichen 19 der Lüftereinrichtung 1 vorgesehen sind, um eine zulässige Verriegelung der Lüftereinrichtung 1 an dem Wandabschnitt 3 zu gewährleisten.

Insgesamt schafft die vorliegende Erfindung eine vorteilhafte Lüftereinrichtung und vorteilhafte Verriegelungselemente, die anders als die herkömmlichen Verriegelungsmechanismen keine exzessive Druckausübung auf die Lüftereinrichtung zur Erzeugung einer Verrastung benötigen. Vielmehr wird ein Hintergreifen der Verriegelungselemente derart erreicht, dass das Verriegelungselement in seiner Fixierstellung mit der Innenseite 25 des Wandabschnitts 3 in Eingriff kommt, wobei eine Druckausübung ausschließlich auf das Verriegelungselement und nicht auf die Vorderseite des Wandabschnitts 3 erfolgt. Auf diese Weise wird eine schonende Befestigung der Lüftereinrichtung 1 an den Wandabschnitt 3 geschaffen, die Verformungen eines Wandabschnitts 3 vermeidet.

### Bezugszeichenliste

- 1: Lüftereinrichtung
- 3: Wandabschnitt
- 5: Lüfterträger
- 7: Abdeckhaube
- 9: Stufe
- 11: Rahmen
- 13: Lasche
- 15: Spannhaken
- 17: Seitenbereich
- 19: Eckbereich
- 21: Einbaurichtung
- 23: Führungseinrichtung
- 25: Innenseite
- 27: Drehriegel
- 29: Lager
- 31: Raststufen
- 33: Rastnase
- 35: Drehrichtung
- 37: distales Ende
- 39: Druckfläche
- 41: erster Abschnitt
- 43: zweiter Abschnitt
- 45: Aufnahmebereich
- 47: Federarm
- 49: Spannfederelement
- 51: Öffnung
- 53: Vorsprung
- 55: Federarm
- 57: Ausnehmung
- A: Verriegelungselement
- B: Verriegelungselement
- C: Verriegelungselement
- D: Drehachse

## Patentansprüche

1. Lüftereinrichtung (1) mit mindestens einem Verriegelungselement (A, B) zur Befestigung der Lüftereinrichtung (1) an einem eine Vorder- und Rückseite aufweisenden Wandabschnitt (3), insbesondere an einer Schaltschrankwand,
**dadurch gekennzeichnet, dass**
die Lüftereinrichtung (1) dazu ausgebildet ist, drucklos in eine vorderseitige Wandabschnittöffnung (51) eingeführt zu werden, und das Verriegelungselement (A, B) im eingeführten Zustand in Richtung der Rückseite des Wandabschnitts verlagerbar ist,
wobei das Verriegelungselement (A, B) zur Befestigung der Lüftereinrichtung (1) an verschiedene Wanddicken stufenlos anpassbar ist, und
wobei das Verriegelungselement (A, B)
als Drehriegel (27), der drehbar an der Lüftereinrichtung (1) gelagert ist, oder
als Lasche (13) mit einem Spannhaken (15), wobei die Lasche (13) zusammen mit dem Spannhaken (15) entgegen einer Einbaurichtung der Lüftereinrichtung geradlinig verschiebbar ist,
ausgebildet ist.

2. Lüftereinrichtung nach Anspruch 1,
**dadurch gekennzeichnet, dass**
das mindestens eine Verriegelungselement (A, B) beweglich an der Lüftereinrichtung (1) gelagert ist und zur Befestigung der Lüftereinrichtung (1) an dem Wandabschnitt (3) manuell von einer Einbaustellung in eine Fixierstellung verlagerbar ist, wobei die Lüftereinrichtung in der Einbaustellung des Verriegelungselements (A, B) drucklos in einen Wandabschnitt einführbar ist.

3. Lüftereinrichtung nach Anspruch 1 oder 2,
**dadurch gekennzeichnet, dass**
das mindestens eine Verriegelungselement (A, B) den Wandabschnitt (3) zumindest in der Fixierstellung hintergreift.

4. Lüftereinrichtung nach einem der vorhergehenden Ansprüche,
**dadurch gekennzeichnet, dass**
das mindestens eine Verriegelungselement (A, B) ein Gehäuse der Lüftereinrichtung (1) durchgreift und relativ dazu verlagerbar ist.

5. Lüftereinrichtung nach einem der vorhergehenden Ansprüche,
**dadurch gekennzeichnet, dass**
jeweils ein Verriegelungselement (A, B) in einem inneren Randbereich der Lüftereinrichtung (1), und insbesondere in mindestens zwei Eckbereichen (19) eines Lüfterträgers (5), angeordnet ist.

6. Lüftereinrichtung nach einem der vorhergehenden Ansprüche,
**dadurch gekennzeichnet, dass**
das mindestens eine Verriegelungselement (A, B) in einem Seitenbereich (17) eines Lüfterträgers (5) angeordnet ist.

7. Lüftereinrichtung nach einem der vorhergehenden Ansprüche,
**dadurch gekennzeichnet, dass**
das Verriegelungselement (A, B) zur Befestigung der Lüftereinrichtung (1) an unterschiedlich dicken Wandabschnitten (3) mehrere Rastpositionen einnehmen kann.

8. Lüftereinrichtung nach einem der vorhergehenden Ansprüche,
**dadurch gekennzeichnet, dass**
die Bewegungsrichtung des Verriegelungselements (A, B) durch eine Führungseinrichtung (23) festgelegt ist.

9. Lüftereinrichtung nach einem der vorhergehenden Ansprüche,
**dadurch gekennzeichnet, dass**
die Lüftereinrichtung (1) dazu ausgebildet ist, drucklos in die vorderseitige Wandabschnittöffnung (51) in eine Einführrichtung eingeführt zu werden, und das Verriegelungselement (A, B) im eingeführten Zustand der Lüftereinrichtung (1) in Richtung der Rückseite des Wandabschnitts entgegensetzt zur Einführrichtung zum Verriegeln verlagerbar ist.

## Claims

1. Fan device (1) having at least one locking element (A, B) for fastening the fan device (1) on a wall portion (3) which comprises a front side and a rear side, in particular on a wall of a switching cabinet,
**characterized in that** the fan device (1) is realized for the purpose of being inserted in a pressure-less manner into a front-side opening (51) in the wall portion and, in the inserted state, the locking element (A, B) is displaceable in the direction of the rear side of the wall portion, the locking element (A, B) being steplessly adaptable to different wall thicknesses for fastening the fan device (1), and the locking element (A, B) being realized as a rotating locking bar (27) which is mounted on the fan device (1) so as to be rotatable or as a tongue (13) which has a tensioning hook (15), the tongue (13) together with the tensioning hook (15) being displaceable in a straight line in opposition to a mounting direction of the fan device.

2. Fan device according to Claim 1,
**characterized in that** at least one locking element (A, B) is mounted as to be movable on the fan device (1) and is displaceable manually from a mounting position into a fixing position for fastening the fan device (1) on the wall portion (3), wherein the fan device is introducible in a pressure-less manner into a wall portion with the locking element (A, B) in the mounting position.

3. Fan device according to Claim 1 or 2,
**characterized in that** the at least one locking element (A, B) engages behind the wall portion (3) at least in the fixing position.

4. Fan device according to one of the preceding claims,
**characterized in that** at least one locking element (A, B) reaches through a housing of the fan device (1) and is displaceable relative thereto.

5. Fan device according to one of the preceding claims,
**characterized in that** a locking element (A,B) is arranged in each case in an inner edge region of the fan device (1) and in particular in at least two corner regions (19) of the fan carrier (5).

6. Fan device according to one of the preceding claims,
**characterized in that** at least one locking element (A, B) is arranged in a side region (17) of a fan carrier (5).

7. Fan device according to one of the preceding claims,
**characterized in that** the locking element (A, B) is able to assume several latching positions for fastening the fan device (1) onto variously thick wall portions (3).

8. Fan device according to one of the preceding claims,
**characterized in that** the movement direction of the locking element (A, B) is determined by a guide device (23).

9. Fan device according to one of the preceding claims,
**characterized in that** the fan device (1) is realized for the purpose of being inserted in a pressure-less manner into the front-side opening (51) in the wall portion in an insertion direction and, with the fan device (1) in the inserted state, the locking element (A, B) is displaceable for locking in the direction of the rear side of the wall portion in opposition to the insertion direction.

## Revendications

1. Dispositif de ventilateur (1) comportant au moins un élément de verrouillage (A, B) pour la fixation du dispositif de ventilateur (1) à une partie de paroi (3) présentant une face avant et une face arrière, en particulier à une paroi d'une armoire de distribution, **caractérisé en ce que** le dispositif de ventilateur (1) est conçu pour être inséré sans pression dans une ouverture (51) de la face avant de la partie de paroi, et l'élément de verrouillage (A, B) peut être déplacé dans l'état inséré en direction de la face arrière de la partie de paroi, dans lequel l'élément de verrouillage (A, B) peut être adapté de façon continue à différentes épaisseurs de paroi pour la fixation du dispositif de ventilateur (1), et dans lequel l'élément de verrouillage (A, B) est réalisé en forme de verrou rotatif (27), qui est monté de façon rotative sur le dispositif de ventilateur (1), ou sous forme de patte (13) avec un crochet de serrage (15), dans lequel la patte (13) peut être déplacée en ligne droite en même temps que le crochet de serrage (15) contre une direction d'introduction du dispositif de ventilateur.

2. Dispositif de ventilateur selon la revendication 1, **caractérisé en ce que** ledit au moins un élément de verrouillage (A, B) est monté de façon mobile sur le dispositif de ventilateur (1) et peut, pour la fixation du dispositif de ventilateur (1) à la partie de paroi (3), être déplacé manuellement d'une position de mise en place à une position de fixation, dans lequel le dispositif de ventilateur peut être introduit sans pression dans une partie de paroi dans la position de mise en place de l'élément de verrouillage (A, B).

3. Dispositif de ventilateur selon la revendication 1 ou 2, **caractérisé en ce que** ledit au moins un élément de verrouillage (A, B) s'accroche à l'arrière de la partie de paroi (3) au moins dans la position de fixation.

4. Dispositif de ventilateur selon l'une quelconque des revendications précédentes, **caractérisé en ce que** ledit au moins un élément de verrouillage (A, B) traverse un boîtier du dispositif de ventilateur (1) et est déplaçable par rapport à celui-ci.

5. Dispositif de ventilateur selon l'une quelconque des revendications précédentes, **caractérisé en ce qu'**un élément de verrouillage (A, B) est disposé respectivement dans une région de bord intérieure du dispositif de ventilateur (1), et en particulier dans au moins deux régions d'angle (19) d'un support de ventilateur (5).

6. Dispositif de ventilateur selon l'une quelconque des revendications précédentes, **caractérisé en ce que** ledit au moins un élément de verrouillage (A, B) est disposé dans une région latérale (17) d'un support de ventilateur (5).

7. Dispositif de ventilateur selon l'une quelconque des revendications précédentes, **caractérisé en ce que** l'élément de verrouillage (A, B) peut prendre plusieurs positions d'encliquetage pour la fixation du dispositif de ventilateur (1) à des parties de paroi d'épaisseur différente (3).

8. Dispositif de ventilateur selon l'une quelconque des revendications précédentes, **caractérisé en ce que** la direction de déplacement de l'élément de verrouillage (A, B) est déterminée par un dispositif de guidage (23).

9. Dispositif de ventilateur selon l'une quelconque des revendications précédentes, **caractérisé en ce que** le dispositif de ventilateur (1) est conçu pour être introduit sans pression dans une direction d'introduction dans une ouverture (51) de la face avant d'une partie de paroi, et l'élément de verrouillage (A, B) peut être déplacé, dans l'état inséré du dispositif de ventilateur (1), en direction de la face arrière de la partie de paroi à l'opposé de la direction d'introduction pour effectuer le verrouillage.
